# EUROPÄISCHE PATENTSCHRIFT

(11) **EP 2 626 647 B1**
(45) Veröffentlichungstag und Bekanntmachung des Hinweises auf die Patenterteilung: **11.06.2014**
(21) Anmeldenummer: 13001950.8
(22) Anmeldetag: 30.03.2011
(51) Int. Cl.: F24H 3/04, H01R 9/22, F24H 1/00, H05K 3/20, H05K 3/32

(54) **Verfahren zur Herstellung eines Leiterbahnen aufweisenden Plattenelementes**
Method for producing a plate element comprising a circuit board
Procédé de fabrication d'un élément plat comprenant des circuits

(43) Veröffentlichungstag der Anmeldung: 14.08.2013
(62) Teilanmeldung aus: 11002637.4
(73) Patentinhaber: Eberspächer catem GmbH & Co. KG, 76863 Herxheim bei Landau (DE)
(72) Erfinder: Bohlender, Franz, 76870 Kandel (DE); Walz, Kurt, 76767 Hagenbach (DE); Götzelmann, Robert, 76187 Karlsruhe (DE); Niederer, Michael, 76889 Kapellen-Drusweiler (DE); Dieter, Emanuel, 76855 Annweiler (DE)
(74) Vertreter: Grünecker, Kinkeldey, Stockmair & Schwanhäusser

(56) Entgegenhaltungen:
- DE-A1-102009 026 459

## Beschreibung

Die vorliegende Erfindung betrifft ein Verfahren zur Herstellung eines Leiterbahnen aufweisenden Plattenelementes gemäß dem Oberbegriff des Anspruchs 1.

Das Plattenelement ist insbesondere für eine elektrische Heizvorrichtung mit mehreren elektrischen Heizelementen, die von einem Gehäuse gehalten werden und an Wärmeleitflächen anliegen, die von zu erwärmendem Medium anströmbar sind. Die Heizelemente der elektrischen Heizvorrichtung sind für deren elektrischen Anschluss mit Kontaktzungen versehen. Sämtliche oder einige dieser Kontaktzungen sind im Wesentlichen höhengleich angeordnet und über das Plattenelement angeschlossen, welches mit Leiterbahnen versehen ist und zur elektrischen Kontaktierung der Kontaktzungen Kontaktzungenaufnahmen aufweist.

Eine solche elektrische Heizvorrichtung ist beispielsweise aus der auf die Anmelderin zurückgehenden EP 1 872 986 A1 bekannt. Bei diesem Stand der Technik bildet das Gehäuse eine Kammer aus, in der die Wärme der elektrischen Heizelemente an ein flüssiges Medium übertragen wird. Die elektrischen Heizelemente liegen hierzu in mehreren U-förmig ausgebildeten Heizkammern und stehen wärmeleitend in Kontakt mit den Wandungen der Heizkammern, die außenseitig von der Flüssigkeit angeströmt werden.

Eine Heizvorrichtung, die mit dem Leiterbahnen aufweisenden Plattenelement ausgestattet ist, kann aber auch durch einen elektrischen Zuheizer zur Erwärmung von Luft des Fahrzeuginnenraumes gebildet sein. In diesem Fall wird das Gehäuse üblicherweise durch einen Rahmen ausgeformt, in dem mehrere elektrische Heizelemente in einem Schichtaufbau gehalten sind, der Radiatorelemente umfasst, die an den elektrischen Heizelementen anliegen und von der zu erwärmenden Luft durchströmt werden. Die elektrischen Heizelemente umfassen auch hier PTC-Elemente mit beidseitig daran anliegenden Blechbändern. Einzelne Blechbänder sind zur Ausbildung von Kontaktzungen seitlich über den Schichtaufbau hinausgeführt. Eine solche elektrische Heizvorrichtung ist beispielsweise durch die EP 1 157 867 A1 beschrieben.

Bei den Heizvorrichtungen besteht die Notwendigkeit einer einfachen Kontaktierung der elektrischen Heizelemente. Dabei gilt, dass die elektrischen Heizelemente üblicherweise in dem Gehäuse vormontiert werden, bevor ein elektrischer Anschluss der elektrischen Heizelemente erfolgt. So wird regelmäßig eine Steckverbindung gefordert, die einen einfachen aber effektiven und dauerhaften elektrischen Anschluss an die Kontaktzungen der elektrischen Heizelemente erlaubt.

Die aus der EP 1 872 986 A1 bekannte elektrische Heizvorrichtung hat mehrere in parallelen Reihen vorgesehene elektrische Heizelemente. Jedes einzelne Heizelement hat zwei Kontaktzungen, die jeweils über das Plattenelement angeschlossen werden müssen. Die EP 1 872 986 A1 offenbart hierzu eine Leiterplatte mit Leiterbahnen für die jeweiligen Kontaktzungen und Kontaktzungenaufnahmen, die elektrisch mit den Leiterbahnen verbunden sind, verschiedene Kontaktzungen zu einem Heizkreis gruppiert und darüber hinaus Flachstecker trägt. Diese Flachstecker sind in Aufnahmen einer weiteren Leiterplatte eingebracht und elektrisch mit dieser verbunden, die die Schaltung zum Steuern bzw. Regeln der elektrischen Heizvorrichtung umfasst und über welche die einzelnen Heizkreise geschaltet werden können.

Das Dokument DE 10 2009026459 offenbart den Oberbegriff des Anspruchs 1.

Die Herstellung einer Leiterplatte ist indes kostenintensiv. Darüber hinaus erlaubt die Leiterplatte wegen der darin fest vorgegebenen Leiterbahnen keine Anpassung zur Ausbildung unterschiedlicher Heizkreise bzw. unterschiedlicher Leiterbahnen. Des Weiteren sind beispielsweise die Kontaktzungenaufnahmen auf die Leiterplatte angelötet und so mit den Leiterbahnen elektrisch verbunden. Dies erfordert nicht nur ein aufwendiges Herstellungsverfahren, sondern begrenzt darüber hinaus die Einsatztemperatur des vorbekannten Plattenelementes.

Die vorliegende Erfindung will ein vereinfachtes Verfahren zur Herstellung eines Leiterbahnen aufweisenden Plattenelementes angeben.

Zur Lösung des vorrichtungsmäßigen Problems wird mit der vorliegenden Erfindung ein Verfahren zur Herstellung eines Leiterbahnen aufweisenden Plattenelementes mit den Merkmalen von Anspruch 1 angegeben. Erfindungsgemäß wird das die Leiterbahnen aufweisende Plattenelement hergestellt, indem zunächst die Metallplatte zur Ausformung der Leiterbahnen sowie von über Verbindungsstege miteinander verbundenen Flächenelemente und den in den Flächenelementen vorgesehenen Kontaktzungenaufnahmen stanzbearbeitet bzw. stanz-biege-bearbeitet wird. Erst danach erfolgt das Fügen mit der Trägerplatte. Diese wird erfindungsgemäß mittels Spritzgießen aus Kunststoff hergestellt. Erst nach dem Fügeprozess werden die Verbindungsstege durchtrennt, um die zuvor einheitlich hergestellten und miteinander verbundenen Flächenelemente elektrisch zu isolieren. Regelmäßig wird die Trägerplatte zunächst unabhängig von der Metallplatte hergestellt. Es ist aber nicht auszuschließen, dass beide Bauelemente durch Umspritzen der Metallplatte gefügt und dabei gleichzeitig die Trägerplatte hergestellt wird.

Im Rahmen des erfindungsgemäßen Verfahrens wird beim Fügen vorzugsweise jedes Flächenelement formschlüssig mit der Trägerplatte verbunden, um die einzelnen Flächenelemente auch nach dem Durchtrennen der Verbindungsstege sicher an der Trägerplatte zu halten.

Gemäß einer weiteren bevorzugten Ausgestaltung der erfindungsgemäßen Verfahrensführung wird der Flachstecker nach dem Fügen von Trägerplatte und Metallplatte in den zugeordneten Flachsteckerhalter eingeschoben. Am Ende dieser Einschiebebewegung, welches üblicherweise durch einen an dem Flachstecker ausgeformten Steckanschlag vorgegeben ist, verrastet der Flachstecker in dem Flachsteckerhalter und an dem Plattenelement ausgeformte Flachsteckerkontaktaufnahmen werden elektrisch mit den zugehörigen Flachsteckern als Steckverbindung kontaktiert. Folglich ergibt sich im Rahmen der Einschiebebewegung sowohl eine mechanische Befestigung des Flachsteckers wie auch eine elektrische Ankopplung an die stanzbearbeitete Metallplatte.

Das Plattenelement umfasst hierbei insbesondere eine Trägerplatte aus einem nichtleitenden Material und eine stanzbearbeitete Metallplatte. Die Trägerplatte und die stanzbearbeitete Metallplatte sind miteinander zu einer Einheit verbunden.

Die Trägerplatte wird üblicherweise aus einem elektrisch nicht leitenden Kunststoff, vorzugsweise mittels Spritzgießen hergestellt, so dass die Trägerplatte weitere Funktionsflächen oder -elemente aufweisen kann, die den Einbau in oder an das Gehäuse, die der Vervollständigung des Gehäuses oder aber der Montage weiterer Bauteile wie Elektronik oder Kabelführung dienen, erlauben. Als Kunststoff kommt dabei beispielsweise Procan, PPT GF30 (CTI 600) oder ein anderer, relativ Wärme beständiger Kunststoff in Betracht. Dies bietet die Möglichkeit, das Plattenelement höheren Temperaturen auszusetzen, insbesondere dann, wenn die elektrische Anbindung an die Metallplatte lediglich über Stecken und ohne jegliche Lötverbindung erfolgt. Das die strukturelle Integrität des Plattenelementes ausbildende Bauteil, d.h. die Trägerplatte kann beliebig und lediglich begrenzt durch die Möglichkeiten der spritzgießtechnischen Herstellung ausgeformt sein. Die Leiterbahnen werden indes bei dem erfindungsgemäßen Plattenelement durch eine stanzbearbeitete Metallplatte ausgeformt. Diese stanzbearbeitete Metallplatte kann kostengünstig vorbereitet und danach mit der Trägerplatte verbunden werden.

Das Fügen von verschiedenen Bauteilen zur elektrischen Anbindung der elektrischen Heizelemente an das Plattenelement kann insbesondere dadurch verhindert werden, dass die Kontaktzungenaufnahmen einteilig durch Stanzen und Biegen an der Metallplatte ausgeformt sind. Die Metallplatte ist hierzu vorzugsweise aus einem federharten, gut kontaktierbarem Material gebildet, wie beispielsweise aus CuSnNi1Mg, welches mit einer dünnen Beschichtung von wenigen µm Silber und/oder Kupfer/Zinn beschichtet ist. Die Kontaktzungenaufnahmen haben dabei zur definierten Kontaktierung der Kontaktzungen an gegenüberliegende Seitenflächen der Kontaktzungen anlegbare Kontaktfedern, die unter vorbestimmter Vorspannung gegen die Kontaktzungen anliegen.

Die Leiterbahnen sowie die zum Anschluss der Kontaktzungen notwendigen Elemente können einteilig durch Stanzen und Biegen einer Metallplatte ausgebildet sein, die zur Versteifung und zur Positionierung an dem Gehäuse mit der hierfür speziell ausgeformten und aus kostengünstigem Kunststoff hergestellten Trägerplatte verbunden wird.

Zur weiteren Vereinfachung des elektrischen Anschlusses wird vorzugsweise vorgeschlagen, dass zumindest ein Flachstecker von einem einteilig an der Trägerplatte ausgeformten Flachsteckerhalter gehalten ist. Der bzw. die Flachstecker überragen üblicherweise die Trägerplatte einseitig und zwar in der Regel auf der der Metallplatte abgewandten Oberseite. Zur elektrischen Kontaktierung des Flachsteckers weist die Metallplatte eine korrespondierend zu dem Flachstecker ausgebildete Flachsteckerkontaktaufnahme aus. Auch diese Flachsteckerkontaktaufnahme ist vorzugsweise mit Kontaktfedern versehen, so dass eine elektrische Kontaktierung des Flachsteckers allein durch Einstecken desselben in die Flachsteckerkontaktaufnahme erfolgt.

Nach alledem weist die stanzbearbeitete Metallplatte des Plattenelementes vorzugsweise lediglich durch Stanzen herausgeschnittene Leiterbahnen sowie Aufnahmen für die Kontaktzungen einerseits und die Flachstecker andererseits auf, über welche unmittelbar eine elektrische Kontaktierung mit den Leiterbahnen beim Einstecken der Kontaktzungen bzw. der Flachstecker erfolgt. Das Plattenelement der vorliegenden Erfindung lässt sich daher leicht mit den elektrischen Heizelementen einerseits und einer Stromversorgung bzw. einer Schaltung hierzu kontaktieren.

Der Flachstecker ist vorzugsweise aus einem Blechstreifen gebildet und hat zumindest einen von der Seitenflächen des Blechstreifens abragenden und durch Stanzen und Biegen hergestellten Verriegelungsvorsprung. Über diesen Verriegelungsvorsprung ist der Flachstecker mit dem Flachsteckerhalter verrastet. Üblicherweise weist der Flachsteckerhalter hierzu einen Hinterschnitt auf, der im Anschluss an einen Einführ- und Haltekanal für den Flachstecker ausgeformt ist und in welchen der Verriegelungsvorsprung hereinfedert, nachdem der Verriegelungsvorsprung den besagten Kanal passiert hat. Der Verriegelungsvorsprung verhindert danach ein Herausziehen des Flachsteckers in entgegen gesetzter Richtung durch Anlage an den Hinterschnitt.

Zur einfachen Verbindung zwischen der Trägerplatte und der stanzbearbeiteten Metallplatte sind an der Trägerplatte vorzugsweise einteilig ausgeformte Halteelemente vorgesehen, über welche die Metallplatte mit der Trägerplatte verrastet werden kann. Die Fügebewegung führt danach vorzugsweise zu einer formschlüssigen Verbindung zwischen der stanzbearbeiteten Metallplatte und der Trägerplatte.

Die Trägerplatte hat dabei üblicherweise mehrere entsprechende Halteelemente, die einteilig an der Trägerplatte ausgeformt sind. Diese übergreifen üblicherweise zumindest den Randbereich der stanzbearbeiteten Metallplatte.

Zur sicheren und vollflächigen Befestigung der Metallplatte an dem Trägerelement weist die Metallplatte eine dem Halteelement zugeordnete Halteöffnung auf, die von dem Halteelement zum Verrasten gegen die Metallplatte durchsetzt ist. Regelmäßig weist die stanzbearbeitete Metallplatte mehrere solcher Halteöffnungen auch in ihrem mittleren Flächenbereich auf. Damit wird die stanzbearbeitete Metallplatte nicht nur randseitig, sondern auch in ihrem mittleren Bereich und vorzugsweise über deren gesamte Längserstreckung an verschiedenen Stellen an der Trägerplatte verrastet und somit sicher an dieser gehalten.

Eine besonders sichere Verrastung ergibt sich insbesondere, wenn bei welcher die Halteöffnung im Wesentlichen mittig von einem Halteelementsteg überbrückt ist, der einteilig an der Trägerplatte ausgeformt ist und von dem beidseitig daran angeformte Federstege und daran vorgesehene und die Metallplatte hintergreifende Rastnasen abragen. Vorzugsweise hat die Metallplatte mehrere, einem Heizkreis der elektrischen Heizvorrichtung zugeordnete und die elektrischen Leiterbahnen gruppierende Flächenelemente. Diese Flächenelemente sind zunächst durch Verbindungsstege miteinander verbunden, so dass die Metallplatte als einheitliches Bauteil durch Stanzen und Biegen vorbereitet werden kann. Jedem einzelnen Flächenelement ist zumindest einer der Flachstecker zugeordnet. Die Trägerplatte weist Stanzöffnungen aus, welche die Verbindungsstege freilassen. Der Verbindungssteg durchsetzt üblicherweise in etwa mittig eine entsprechende Stanzöffnung. Die üblicherweise mittels Spritzgießen ausgeformte Stanzöffnung erlaubt das Durchtrennen der Verbindungsstege nach der Montage der stanzbearbeiteten Metallplatte, um die einzelnen Flächenelemente elektrisch voneinander zu isolieren. Dabei ist üblicherweise jedem einzelnen Flächenelement auf Seiten der Trägerplatte zumindest eines der Halteelemente zugeordnet.

Weitere Einzelheiten und Vorteile der vorliegenden Erfindung ergeben sich aus der nachfolgenden Beschreibung eines Ausführungsbeispiels eines nach dem erfindungsgemäßen Verfahren hergestellten Erzeugnisses in Verbindung mit der Zeichnung. In dieser zeigen:
- Figur 1: eine perspektivische Explosionsdarstellung einer oberseitigen Ansicht eines Plattenelementes nach dem Ausführungsbeispiel;

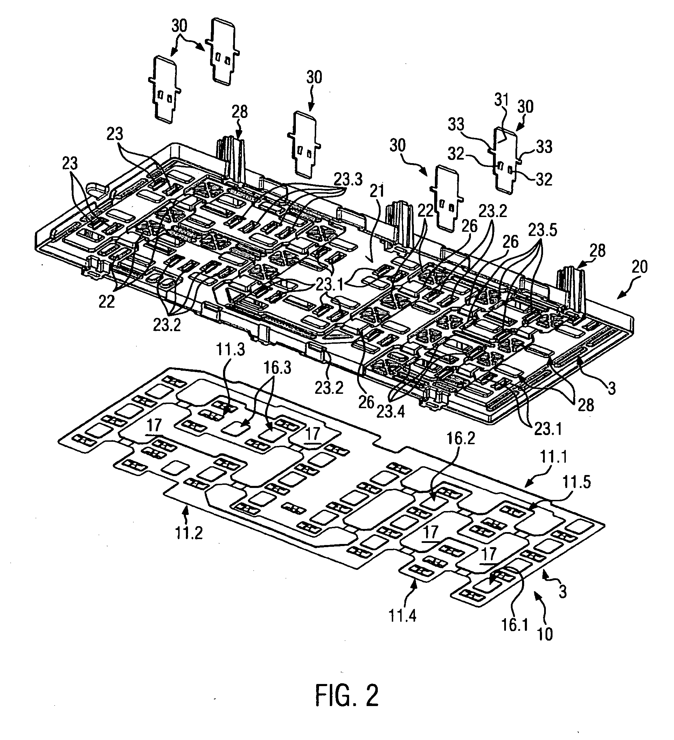

- Figur 2: eine perspektivische Explosionsdarstellung einer unterseitigen Ansicht eines Plattenelementes nach dem Ausführungsbeispiel;
- Figur 3: eine perspektivische Draufsicht auf die Oberseite des in den Figuren 1 und 2 gezeigte Ausführungsbeispiel nach dem Fügen sämtlicher Bauteile;
- Figur 4: eine perspektivische Draufsicht auf die Unterseite des in den Figuren 1 und 2 gezeigte Ausführungsbeispiel nach dem Fügen sämtlicher Bauteile;
- Figur 5: eine Schnittansicht entlang der Linie V-V gemäß Figur 3;
- Figur 6: eine Schnittansicht entlang der Linie VI-VI gemäß der Darstellung in Figur 3 und
- Figur 7: das Detail VII gemäß Figur 3.

Bei dem in den Figuren verdeutlichten Bauteil handelt es um das Plattenelement einer an sich beispielsweise aus der EP 1 872 986 A1 bekannten elektrischen Heizvorrichtung mit mehreren in parallelen Reihen angeordneten elektrischen Heizelementen. Auf die spezielle Beschreibung der EP 1 872 986 A1 wird insofern verwiesen. Der Offenbarungsgehalt dieser Patentanmeldung wird durch Bezugsnahme in den Offenbarungsgehalt der vorliegenden Anmeldung aufgenommen. In der nachfolgenden speziellen Beschreibung wird lediglich näher auf das in der EP 1 872 986 A1 als Verteilerplatte bezeichnete Bauteil eingegangen.

Dieses Plattenelement ist in den Figuren mit Bezugszeichen 1 gekennzeichnet und besteht aus einer Metallplatte 10, einer Trägerplatte 20 und mehreren Flachsteckern 30.

In den Figuren wird des Weiteren mit Bezugszeichen 2 die Oberseite und mit Bezugszeichen 3 die Unterseite des jeweiligen Bauteils gekennzeichnet.

Die Metallplatte 10 ist durch Stanzen und Biegen eines federharten Kontaktmaterials wie beispielsweise CuSnNi1Mg mit einer 2,5 µm dicken Silberbeschichtung gebildet. Durch die Stanzbearbeitung ist die Metallplatte zu einer gitterförmigen Ausgestaltung umgeformt. Die Metallplatte 10 hat fünf Flächenelemente 11, die jeweils über Verbindungsstege 12 miteinander verbunden sind. Jedes Flächenelement 11 hat mehrere Kontaktzungenaufnahmen 13, die durch Freischneiden einer Einbringöffnung unter Stehenlassen von Kontaktfedern 14, die von gegenüberliegenden Seitenrändern der Einbringöffnung abragen, gebildet ist. Durch Biegen sind diese freigestanzten Kontaktfedern zur Oberseite 2 der Metallplatte 10 hin gerichtet, so dass sich von der Unterseite 3 her eine leicht trichterförmige Verengung zu den Spitzen der Kontaktfedern 14 ergibt.

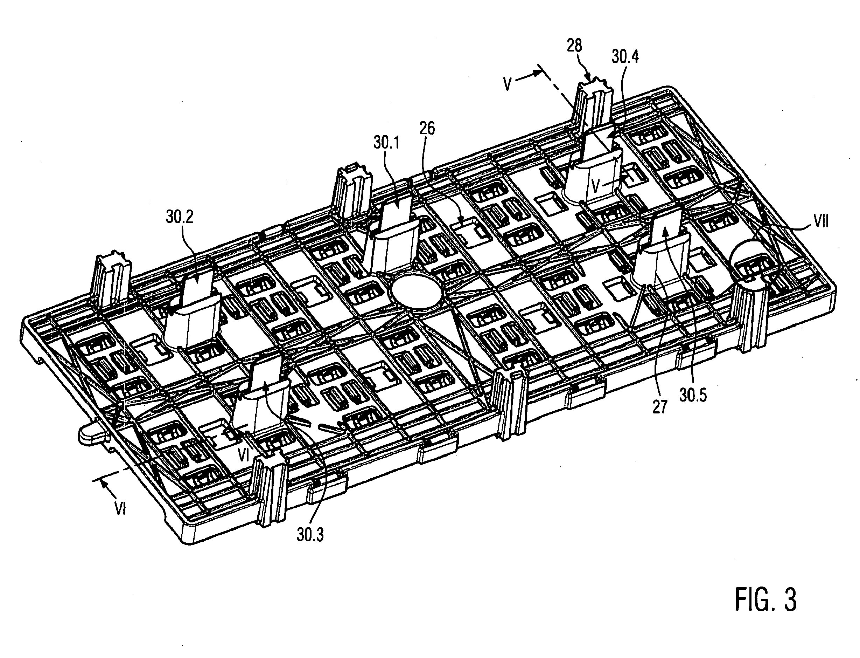

Mit entsprechenden Kontaktfedern 14 sind auch die mit Bezugszeichen 15 gekennzeichneten Flachsteckerkontaktaufnahmen versehen. Zu jedem Flächenelement 11.1 bis 11.5 ist je eine Flachsteckerkontaktaufnahme 15.1 bis 15.5 vorgesehen (Fig. 3).

Durch Stanzen sind ferner an der Metallplatte 10 rechteckige Halteöffnungen 16 sowie Innenöffnungen 17 ausgeformt. Das verbleibende Material der Metallplatte 10 bildet teilweise stegförmige, teilweise flächige Leiterbahnen 18 aus. Sämtliche Funktionselemente und - flächen der Metallplatte 10 sind allein durch Stanz- bzw. Stanz-Biege-Bearbeitung eines tafelförmigen Blechhhalbzeugs ausgebildet.

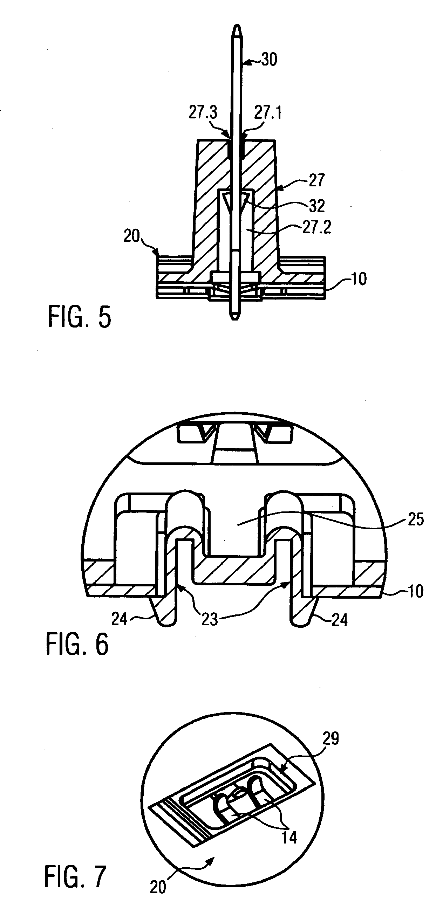

Die Trägerplatte 20 bildet eine ebene Anlagefläche 21 für die Metallplatte 10 aus, die von in die Innenöffnungen 17 der Metallplatte 10 hineinragenden Versteifungssegmenten 22 überragt ist. Die Kontur der Versteifungssegmente 22 entspricht im Wesentlichen der Randkontur der zugeordneten Flächenelemente 11, so dass die Metallplatte 10 relativ zu der Trägerplatte 20 ausgerichtet wird und die Metallplatte 10 nur in vorgegebener Ausrichtung relativ zu der Trägerplatte 20 an diese angelegt werden kann. Die Anlagefläche 21 wird ferner von Federstegen 23 mit Rastnasen 24 überragt, die in Figur 6 vergrößert gezeigt sind und Halteelemente zur formschlüssigen Halterung der Metallplatte 10 an der Trägerplatte 20 ausbilden. Die Federstege 23 und die Rastnasen 24 durchragen hierfür die Halteöffnungen 16 und die Rastnasen 24 hintergreifen die Unterseite 3 der Metallplatte 10. Die Federstege 23 gehen von einem Halteelementsteg 25 ab, welcher nach dem Fügen von Metallplatte 10 und Trägerplatte 20 die Halteöffnungen 16 in etwa mittig überbrückt (vgl. Figur 6). Die Anlagenflächen 21. 4 und 21.5 für die Flächenelemente 11.4 und 11.5 sind randseitig durch Federstege 23.4, 23.5 mit zugeordneten Rastnasen begrenzt, die im gefügten Zustand mit den Seitenrändern der entsprechenden Flächenelemente 11.4 und 11.5 zusammenwirken und diese formschlüssig fixieren.

Auch die Außenkontur der Metallplatte 10 ist über Federstege 23 formschlüssig umgriffen.

Der Lage der Verbindungsstege 12 korrespondierend weist die Trägerplatte 20 Stanzöffnungen 26 auf. Im gefügten Zustand befinden sich die Verbindungsstege 12 in etwa mittig in diesen Stanzöffnungen 26.

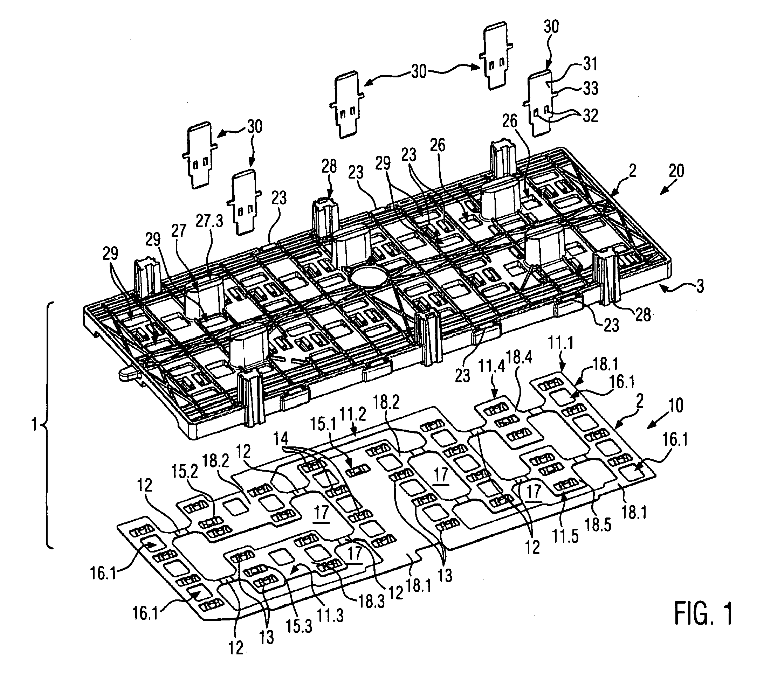

Die in Figur 1 zu erkennende Oberseite 2 der Trägerplatte 20 wird von fünf Flachsteckerhaltern 27 sowie je drei auf der Längsseite verteilt vorgesehenen Auflagern 28 überragt, die höhengleich mit den Flachsteckerhaltern 27 enden. Jeder Flachsteckerhalter 27 hat einen an die Dicke des Flachsteckers 30 angepasst ausgebildeten Einführkanal 27.1, der zu einem Aufnahmebereich 27.2 führt, der umfänglich von dem die Trägerplatte 20 ausbildenden Kunststoffmaterial umgeben ist und einen Hinterschnitt ausbildet. Korrespondierend zu den Kontaktzungen - bzw. Flachsteckerkontaktaufnahmen 13, 15 sind an der Trägerplatte 20 schließlich Kontakteinbringöffnungen 29 ausgespart.

Sämtliche zuvor beschriebenen Elemente der Trägerplatte 20 sind einteilig an dieser im Wege des Spritzgießens der Trägerplatte 20 ausgeformt.

Der Flachstecker 30 hat von gegenüberliegenden Seitenflächen 31 abragende Verriegelungsvorsprünge 32, die durch Freistanzen und Herausbiegen aus der Blechebene des Flachsteckers 30 ausgebildet sind. Des Weiteren ragen quer von dem Flachstecker 30 Steckanschläge 33 ab, für deren Aufnahme die freie Stirnseite der Flachsteckerhalter 27 mit einer Nut 27.3 versehen sind.

Bei dem gezeigten Ausführungsbeispiel wird zunächst die Trägerplatte 20 einteilig mittels Spritzgießen aus einem warmfesten Kunststoff, beispielsweise PBT hergestellt. Die Metallplatte 10 wird durch Stanzen und Biegen vorbereitet. Danach werden die beiden Bauteile 10, 20 relativ zueinander positioniert. Die Trägerplatte 20 ist dabei üblicherweise mit ihrer Unterseite 3 nach oben gerichtet. Nach dem Auflegen der Metallplatte 10 drückt ein Fügewerkzeug die Metallplatte 10 gegen die Anlageflächen 21 der Trägerplatte 20. Dabei verrasten die Rastnasen 24 gegen die Ränder der Halteöffnungen 16 bzw. gegen den Längsrand der Flächenelemente 11.4, 11.5. In gleicher Weise verrasten am Längsrand der Trägerplatte 20 vorgesehene Federstege 23 gegen die Metallplatte 10 entlang ihrer Außenkontur.

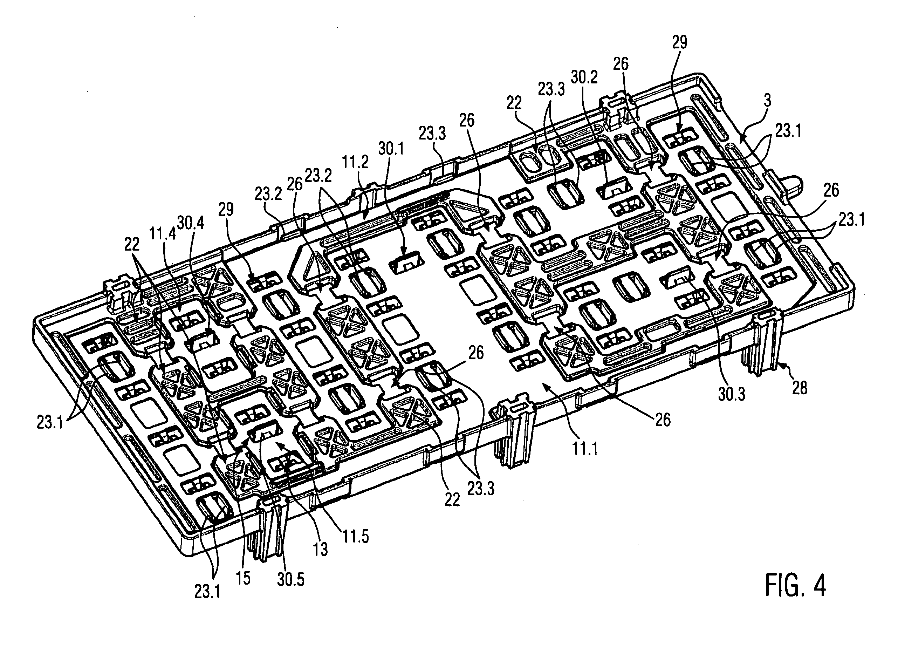

Anschließend wird durch ein Trennwerkzeug, beispielsweise durch ein Stanzwerkzeug eine Trennbearbeitung durchgeführt, in deren Rahmen die Verbindungsstege 12 getrennt werden. Ein Stanzstempel wird dabei durch die Stanzöffnungen eingebracht und die Verbindungsstege 12 abgeschert. Die Reste der Verbindungsstege 12 sind insbesondere in Figur 4 im Bereich der Stanzöffnungen 26 zu erkennen. Es ergeben sich fünf elektrisch jeweils voneinander isoliert vorgesehene Flächenelemente 11.1 bis 11.5.

Danach werden die Flachstecker 30 von der Oberseite 2 in die jeweiligen Einführkanäle 27.1 der zugeordneten Flachsteckerhalter 27 eingeführt. Im Rahmen dieser Einführbewegung werden die Verriegelungsvorsprünge 32 elastisch zurück in die Ebene des Flachsteckermaterials 30 zurückgedrängt. Die Spitze des Flachsteckers 30 drückt schließlich gegen die Kontaktfedern 14 der Flachsteckeraufnahmen 15, so dass die Kontaktfedern 14 der zunächst wie die Kontaktzungenaufnahmen 13 ausgebildeten Flachsteckeraufnahmen 15, die die Oberseite 2 der Metallplatte 10 überragend, mitgenommen und die Unterseite 3 überragend umbogen werden. Die genaue Führung der Flachstecker 30 durch die Einführkanäle 27.1 vereinfacht diese Umformbewegung der Kontaktfedern 14. Das Eindrücken der Flachstecker 30 erfolgt üblicherweise maschinell. Die Einschiebebewegung der Flachstecker endet, wenn die Steckanschläge 33 gegen den Grund der Nut 27.3 des Flachsteckerhalters 27 stoßen. Diese Position ist in Figur 5 in der Schnittdarstellung dargestellt.

Das so vorbereitete Plattenelement 1 wird danach auf die Kontaktzungen der einzelnen elektrischen Heizelemente aufgeschoben, um diese gemäß den Flächenelementen 11.1 bis 11.5 zu Heizkreisen zu gruppieren. Eine der Kontaktzungen der jeweiligen elektrischen Heizelemente wird dabei immer mit dem Flächenelement 11.1 kontaktiert, welches auf Masse liegt, wohingegen die anderen Flächenelemente 11.2 bis 11.4 über den zugeordneten Flachstecker 30.2 bis 30.5 an Schalter, insbesondere Leistungsschalter angeschlossen sind, die mit einer Leiterplatte verlötet sind, die auf den Auflagern 28 und den stirnseitigen Enden der Flachsteckerhalter 27 aufliegt und Flachsteckeraufnahmen zur elektrischen Kontaktierung der Flachstecker 30 mit der Leiterbahn hat (vgl. EP 1 872 986 A1).

Es sei darauf hingewiesen, dass mit dem Ausführungsbeispiel auf einfache Weise die Heizkreise verändert werden können, indem auf das vollständige Entfernen sämtlicher Verbindungsstege 12 verzichtet wird.

### Bezugszeichenliste

- 1: Plattenelement
- 2: Oberseite
- 3: Unterseite
- 10: Metallplatte
- 11: Flächenelement
- 11.1 - 11.5: Flächenelement der einzelnen Heizkreise
- 12: Verbindungssteg
- 13: Kontaktzungenaufnahme
- 14: Kontaktfeder
- 15: Flachsteckerkontaktaufnahme
- 16: Halteöffnung
- 17: Innenöffnung
- 18: Leiterbahnen
- 20: Trägerplatte
- 21: Anlagefläche
- 22: Versteifungssegment
- 23: Federstege
- 24: Rastnase
- 25: Halteelementsteg
- 26: Stanzöffnung
- 27: Flachsteckerhalter
- 27.1: Einführkanal
- 27.2: Aufnahmebereich
- 27.3: Nut
- 28: Auflage
- 29: Kontakteinbringöffnung
- 30: Flachstecker
- 31: Seitenfläche
- 32: Verriegelungsvorsprung
- 33: Steckanschlag

## Patentansprüche

1. Verfahren zum Herstellen eines Leiterbahnen aufweisenden Plattenelementes (1), bei dem eine Trägerplatte (20) mittels Spritzgießen aus Kunststoff hergestellt wird, **dadurch gekennzeichnet, dass** eine Metallplatte (10) zur Ausformung von über Verbindungsstege (12) miteinander verbundenen Flächenelementen (11.1 - 11.5) und in den Flächenelementen (11.1 - 11.5) vorgesehenen Kontaktzungenaufnahmen (13; 15) stanzbearbeitet wird, und dass die Trägerplatte (20) und die Metallplatte (10) gefügt und nachfolgend die Verbindungsstege (12) durchtrennt werden.

2. Verfahren nach Anspruch 1, **dadurch gekennzeichnet, dass** beim Fügen jedes Flächenelement (11.1 - 11.5) formschlüssig mit der Trägerplatte (20) verbunden wird.

3. Verfahren nach Anspruch 1 oder 2, **dadurch gekennzeichnet, dass** Flachstecker (30) in Flachsteckerhalter (27) eingeschoben und am Ende der Einschiebebewegung in den Flachsteckerhaltern (27) verrastet und in an der Metallplatte (10) ausgeformten Flachsteckerkontaktaufnahmen (50) elektrisch mit den zugehörigen Flächenelementen (11) verbunden werden.

## Claims

1. Method of manufacturing a plate element (1) comprising conductive paths for which a carrier plate (20) is manufactured from plastic material by means of injection moulding,
**characterized in that**
a metal plate (10) is subjected to stamping operations for forming area elements (11.1 - 11.5) joined together by connecting ridges (12) and for forming contact lug receptacles (13; 15) provided in the area elements (11.1 - 11.5),
and that the carrier plate (20) and the metal plate (10) are joined and the connecting ridges (12) are then parted.

2. Method according to Claim 1, **characterized in that** during joining, each area element (11.1 - 11.5) is joined positively locked to the carrier plate (20).

3. Method according to Claim 1 or 2, **characterized in that** flat plugs (30) are inserted into flat plug holders (27) and locked in the flat plug holders (27) at the end of the insertion movement and are electrically connected to the assigned area elements (11) in flat plug contact receptacles (50) formed on the metal plate (10).

## Revendications

1. Procédé de fabrication d'un élément de plaque (1) présentant des pistes conductrices de circuit, d'après lequel une plaque de support (20) est fabriquée en matière plastique par moulage par injection, **caractérisé en ce que** l'on façonne par découpage par matriçage une plaque métallique (10) pour former des éléments de surface (11.1 - 11.5) reliés mutuellement par des nervures de liaison (12), ainsi que des logements de réception de languettes de contact (13 ; 15) prévus dans les éléments de surface (11.1 - 11.5), et **en ce que** l'on assemble la plaque de support (20) et la plaque métallique (10) et l'on sectionne ensuite les nervures de liaison (12).

2. Procédé selon la revendication 1, **caractérisé en ce que** lors de l'assemblage, chaque élément de surface (11.1 - 11.5) est relié par complémentarité de formes à la plaque de support (20).

3. Procédé selon la revendication 1 ou la revendication 2, **caractérisé en ce que** des fiches plates (30) sont insérées dans des supports de fiches plates (27), et, à la fin du mouvement d'insertion, viennent s'enclencher dans les supports de fiches plates (27) et se connecter électriquement avec les éléments de surface (11) associés, dans des logements de réception de contact de fiches plates (50) formés dans la plaque métallique (10) .
